# EUROPEAN PATENT APPLICATION

(11) **EP 3 339 244 A1**
(43) Date of publication of application: **27.06.2018**
(21) Application number: 16205939.8
(22) Date of filing: 21.12.2016
(51) Int. Cl.: B82Y 10/00, H01L 29/40, H01L 29/417, H01L 29/66, H01L 29/775, H01L 29/78, H01L 29/06, H01L 29/41, H01L 29/04

(54) **SOURCE AND DRAIN CONTACTS IN FIN- OR NANOWIRE- BASED SEMICONDUCTOR DEVICES.**

(71) Applicant: IMEC vzw, 3001 Leuven (BE)
(72) Inventor: HORIGUCHI, Naoto, 3001 Leuven (BE); HIKAVYY, Andriy, 3001 Leuven (BE); DEMUYNCK, Steven, 3001 Leuven (BE)
(74) Representative: DenK iP

(57) **Abstract**

A method for making a contact (900) to a source or drain region of a nanowire- or fin-FET semiconductor device, comprising:
a. providing the semiconductor device having at least one fin-shaped source or drain region, the source or drain region having an exposed area,
b. partially etching the source or drain region such that the exposed area is increased, by creating a groove in the top-surface (810; Fig. 8a), the side-surface (820; Fig. 2b) or completely dividing the fin-shaped source or drain region into a stack of nanowires (830; Fig. 2c), and
c. providing a contact (900) covering at least the etched part (810; 820; 830) of the source or drain region; wherein the contact (900) contacts the source or drain region on at least 3 sides of the source or drain region.

## Description

### Technical field of the invention

The present invention relates to contacts in semiconductor devices and in particular to decreasing the contact resistance of contacts to source and/or drain regions therein.

### Background of the invention

As scaling of semiconductor devices continues, also the available area for making contacts, such as contacts to the source and/or drain regions, decreases. However, decreasing contact sizes results in an unwanted increase of the contact resistance. There is thus a need to keep the contact resistance low, while still scaling down the contact size. One attempt to achieve this is to form a wrapped around contact, such as described in US 2011/0147840 A1.

There is however still a need within the art to decrease further the contact resistance to source or drain contacts.

### Summary of the invention

It is an object of the present invention to provide good methods for controlling the contact resistance to source or drain contacts.

It is an advantage of embodiments of the present invention that the contact resistance to the source or drain region can be decreased.

It is an advantage of embodiments of the present invention that they are compatible with the formation of wrap around contacts.

The above objective is accomplished by methods and devices according to the present invention.

In a first aspect, the present invention relates to a method for making a contact to a source or drain region of a semiconductor device, comprising:
a. providing the semiconductor device having at least one source or drain region, the source or drain region having an exposed area,
b. partially etching the source or drain region such that the exposed area is increased, and
c. providing a contact covering at least the etched part of the source or drain region;
wherein the contact contacts the source or drain region on at least 3 sides of the source or drain region.

In a second aspect, the present invention relates to a semiconductor structure, comprising:
i. at least one source or drain region, comprising a recess or a separation formed by sides separated by an intervening space, and
ii. a contact covering at least the recess or the sides of the separation and contacting the source or drain region on at least 3 sides of the source or drain region.

In a third aspect, the present invention relates to a semiconductor device comprising the semiconductor structure according to the second aspect or embodiments thereof.

Particular and preferred aspects of the invention are set out in the accompanying independent and dependent claims. Features from the dependent claims may be combined with features of the independent claims and with features of other dependent claims as appropriate and not merely as explicitly set out in the claims.

Although there has been constant improvement, change and evolution of devices in this field, the present concepts are believed to represent substantial new and novel improvements, including departures from prior practices, resulting in the provision of more efficient, stable and reliable devices of this nature.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the drawings

Fig. 1 is a schematic representation of a contact to a source or drain area according to the prior art.
Fig. 2 shows schematic representations of contacts to source or drain areas for several embodiments in accordance with the present invention.
Fig. 3 to 11 shows schematic top views (a) and two cross sections (b and c; sections indicated in a) of different steps in the formation of several embodiments according to the present invention, for both NMOS and PMOS device areas in these embodiments.
Fig. 12 shows a schematic cross section of different steps along the formation of a V-shaped groove in a source or drain region.

In the different figures, the same reference signs refer to the same or analogous elements.

### Description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

Furthermore, some of the embodiments are described herein as a method or combination of elements of a method that can be implemented by a processor of a computer system or by other means of carrying out the function. Thus, a processor with the necessary instructions for carrying out such a method or element of a method forms a means for carrying out the method or element of a method. Furthermore, an element described herein of an apparatus embodiment is an example of a means for carrying out the function performed by the element for the purpose of carrying out the invention.

In the description provided herein, numerous specific details are set forth. However, it is understood that embodiments of the invention may be practiced without these specific details. In other instances, well-known methods, structures and techniques have not been shown in detail in order not to obscure an understanding of this description.

As used herein, a side of a structure is a continuous outer surface of the structure, wherein e.g. a corner constitutes a discontinuity. As such, a curved surface making a smooth rounded bend for example is considered to be a single side of the structure, while a V-shaped groove is considered to comprise two sides.

As used herein, when a first material is said to be etched or recessed selectively with respect to a second material, this means that the first material is etched or recessed faster than the second material. Preferably, the etching or recessing process would etch or recess the first material at least twice faster, or more preferably at least five times faster, yet more preferably at least 10 times faster, than the second material. In some preferred embodiments, the second material may be substantially not etched or recessed by the etching or recessing process.

As used herein, a structure typically has a height, a width and a length. The height being the dimension perpendicular to the substrate. The width and length being the shortest and longest dimension parallel to the substrate, respectively.

In a first aspect, the present invention relates to a method for making a contact to a source or drain region of a semiconductor device, comprising:
a. providing the semiconductor device having at least one source or drain region, the source or drain region having an exposed area,
b. partially etching the source or drain region such that the exposed area is increased, and
c. providing a contact covering at least the etched part of the source or drain region;
wherein the contact contacts the source or drain region on at least 3 sides of the source or drain region.

The semiconductor device is typically a transistor, comprising source and drain regions, a channel region between the source and drain regions and a gate region able to control the flow of charges in the channel region. In embodiments, the semiconductor device may be a fin field effect transistor (FinFET) or a nanowire field effect transistor (Nanowire FET); i.e. the semiconductor device may be a transistor based on a fin or on a nanowire.

The semiconductor device typically comprises a substrate. The substrate typically comprises fins. The source or drain region may be comprised in the substrate. For instance, the source or drain region may be comprised in a fin.

The substrate is typically a semiconductor substrate, such as a Si wafer, or semiconductor-on-insulator substrate (SOI) or strain relaxed buffer (SRB).

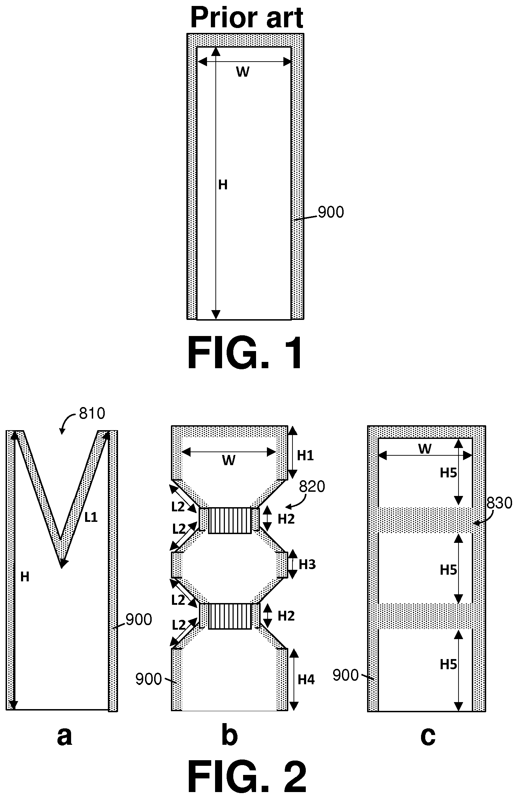

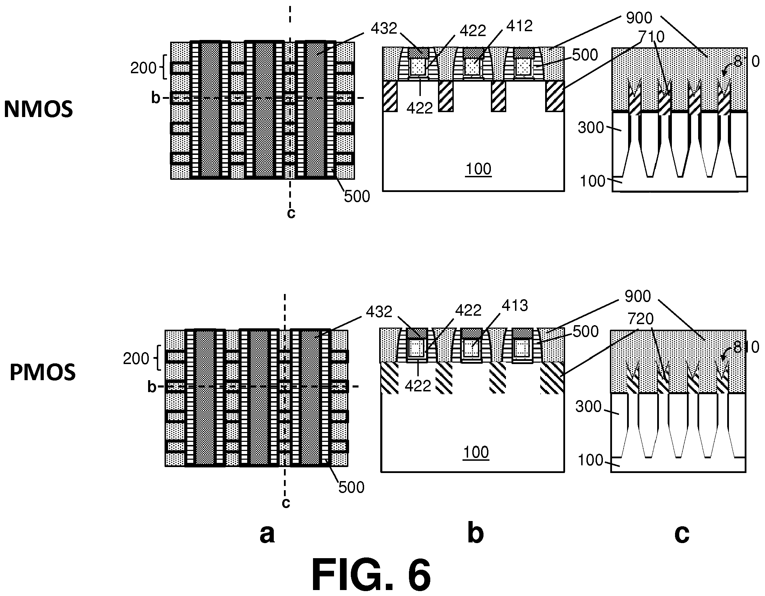

In embodiments, the contact may be a wrapped around contact (i.e. a contact covering at least one sidewall of the source or drain region). In embodiments, the contact may be a layer following the contour of the source or drain region (see e.g. Fig. 2). In embodiments, the contact may be a layer embedding the source or drain region (see e.g. Fig. 6). The contact may typically comprise a metal, such as W, Ti and/or TiN. The contact may for example comprise a Ti layer, a TiN barrier layer and a W contact fill. The contact is a structure, typically a layer, having the function of facilitating an electrical contact with the source or drain.

In embodiments, the source or drain region may comprise a semiconductor material, such as Si, SiGex (wherein x is from 0 to 100%, e.g. SiGe_{50%}) or Ge. In embodiments, the source or drain region may be doped. The source or drain region may for example be doped with phosphorus or arsenic (in the case of an n-type transistor), or with boron (in the case of a p-type transistor).

In step a, the source or drain region may be formed for instance by providing a substrate comprising one or more fins (each fin optionally comprising one or more nanowires extending along its length and superposed along its height) having an exposed top portion, providing spacers on the sides of the fin top portion, removing the top portion of the fin selectively with respect to the spacers, filling the space between the spacers with a doped semiconductor material such as a phosphorus-doped Si or boron-doped SiGe or with alternating layers of two different semiconductor materials such as a phosphor-doped Si and a phosphor doped SiGe or a boron-doped SiGe and a boron-doped Si.

The fins typically have one or more gate structures thereon and spacers on the sides of the gate structures. The gate structures typically comprise a gate dielectric at the interface with the fin, a metal stack on the gate dielectric, and a dielectric cap on the metal stack. The gate structure also typically has a high-k dielectric layer at the interface between the metal stack and the spacers.

In embodiments, partially etching the source or drain region may comprise recessing part of the top side, thereby forming a recess (e.g. a concavity or a cavity) therein, or recessing part of a lateral side of the source or drain region, thereby forming a recess (e.g. a concavity or a cavity) or a separation therein. When the semiconductor device is placed on an horizontal surface, the top side of the source or drain region is typically substantially parallel to that surface. The top side of the source or drain region may for example be at an angle of -15° to 15°, preferably -5° to 5°, with respect to that surface; or it may be parallel thereto. Lateral sides of the source or drain region are typically substantially perpendicular to that surface. The lateral side of the of the source or drain region may for example be at an angle of 75° to 105°, preferably 85° to 95°, such as 90°, with respect to that surface.

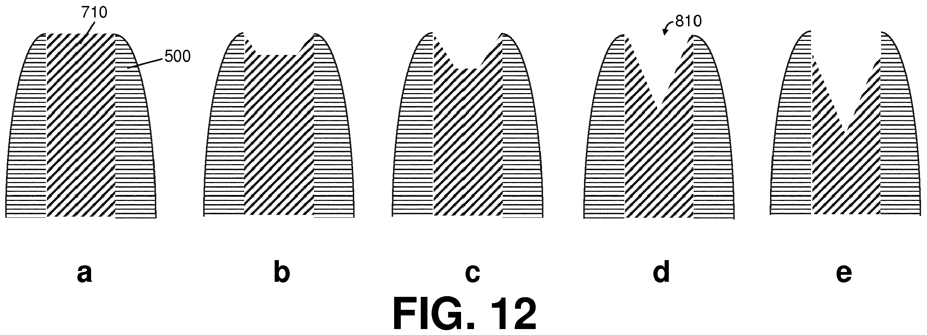

In a first type of embodiments, the recessing step may be performed in a top side of the source or drain region. In embodiments, recessing part of the top side may be performed selectively with respect to spacers present along the sides of the source or drain region. In embodiments, the recess may be a V-shaped groove in the top side. In embodiments, the V-shaped groove may be defined by at least one, preferably two, planes (or facets) of Miller indices (111) of the source or drain region. Since etching rates can typically be anisotropic along different planes, a V-shape defined by (111) planes can typically advantageously be obtained using a suitable etching chemistry, e.g. using HCl to etch SiGe or using tetramethylammonium hydroxide (TMAH) to etch Si. Different steps along the formation of a V-shaped groove defined by (111) planes are depicted in Fig. 12. The etching of a V-shaped groove (810) defined by (111) planes is typically advantageously a self-controlling process, i.e. once the (111) planes have reached the spacer material (500) (Fig. 12d), the etching rate of the material (710) slows down (Fig. 12e) compared to the prior etching (Fig. 12a-c). This self-controlling nature of the process advantageously allows for easier process control.

In a second type of embodiments, the recessing step may be performed in a lateral side of the source or drain region. In embodiments, recessing part of a lateral side may be performed after having removed spacers present along the sides of the source or drain region. In embodiments, the source or drain region may comprise a layer of a first material on top of a layer of a second material and forming the recess in the lateral side may comprise selectively etching at least part of the second material with respect to the first material. Inembodiments, forming the recess may comprise etching away the entire layer of second material. Depending on the dimensions of the recess that is formed, either etching away only part or etching away the entire layer of second material advantageously creates the largest increase of the exposed area. Etching away the entire layer of second material forms a separation in the source or drain region, comprising two newly formed surfaces separated by an intervening space. The newly formed surfaces count as sides of the source or drain region when counting *"at least 3 sides".* In embodiments, the source or drain region may comprise layers of the first material alternated with layers of the second material. When the source or drain region comprises a plurality of layers of the first material, alternated with layers of the second material, then a number of recesses corresponding to the number of layers of the second material may advantageously be formed in each treated lateral side of the source or drain region. A plurality of recesses advantageously allows a larger increase of the exposed area. In embodiments, the first material may be a semiconductor material, such as Si or SiGe (e.g. SiGe_{50%}) or Ge. In embodiments, the second material may be a semiconductor material, such as selected from SiGe and Si, with the proviso that the second material differs from the first material. The first and second material are typically selected in such a way that the second material can be etched selectively with respect to the first material with at least one etching chemistry. For instance, in the case of Si and SiGe, Si can be removed selectively by using tetramethylammonium hydroxide (TMAH) and SiGe can be removed selectively by using an HCl vapor etching.

In embodiments, features of the first and second type of embodiments may be combined. Recesses may for example be formed in both the top side and in one or more lateral sides of the source or drain region.

In embodiments, the contact may cover the exposed area (obtained after step b) completely. In other embodiments, the contact may cover only part of the exposed area.

In embodiments, both an NMOS and a PMOS device region may be present on a substrate. In these embodiments, any step of the process may be applied to either of the NMOS or PMOS device region, separately from the other of the PMOS or NMOS device region. To that end, the PMOS (or NMOS) device region may be covered by a mask layer (e.g. a SiN mask), such that only the NMOS (or PMOS) device region may be processed in a given step.

In embodiments, step a may comprise:
a1. providing a first device region (e.g. either of an PMOS or NMOS device region) and a second device (e.g. the other of a NMOS or PMOS device region) region, each comprising fin structures optionally comprising nanowire structures, at least one gate structure over the fin structure, a spacer material covering lateral sides of the fin structures, a spacer covering the lateral sides of the gate structure, the gate structure being covered by a hardmask on a top side;
a2. covering the first device region with a first mask layer;
a3.forming, in the second device region, second source or drain regions in the fin structures or nanowire structures;
a4. covering the second device region with a second mask layer and removing the first mask layer;
a5.forming, in the first region, first source or drain regions in the fin structures or nanowire structures; and.
a6. removing the second mask layer.

In embodiments, the gate structure in step a1 may be a dummy gate structure and the method may further comprise:
a7. replacing the at least one dummy gate structure by at least one gate structure, the gate structure being covered by the spacer material on lateral sides and by a gate cap on a top side.

In embodiments, step a7 may comprise, prior to replacing the at least one dummy gate structure, filling up a void adjacent to the spacer material with a dielectric material and, after replacing the at least one dummy gate structure, removing the dielectric material.

In embodiments, covering the first or second device region with the first or second mask layer may comprise:
- depositing a mask layer;
- depositing a photoresist layer on the mask layer;
- making an opening in the photoresist layer;
- removing the mask layer beneath the opening and;
- optionally, removing the photoresist layer.

In embodiments, making an opening in the photoresist layer may comprise exposing an area of the photoresist layer to light and removing either the exposed or unexposed area. In embodiments, the mask layer may be a hardmask layer (e.g. a SiN layer).

In embodiments, removing the first or second mask layer may comprise:
- depositing a photoresist layer on the mask layer;
- making an opening in the photoresist layer;
- removing the mask layer beneath the opening and;
- optionally, removing the photoresist layer.

In embodiments, the first and second source or drain regions may each comprise different materials. In embodiments, step b may comprise partially etching the first source or drain regions separately from the second source or drain regions. In embodiments, step b may comprise selectively etching the first source or drain regions with respect to the second source or drain regions. In embodiments, step b may comprise selectively etching the second source or drain regions with respect to the first source or drain regions. In embodiments, forming the source or drain regions may comprise removing the fin or nanowire structure over a section of its length between the spacer material and filling the resulting opening with a source or drain material. In embodiments, the method may comprise uncovering at least one lateral side of the source or drain material prior to step c, such as after step a or after step b. In embodiments, uncovering the at least one lateral side may comprise removing the spacer material covering said at least one lateral side.

In embodiments, a distance between centres of two gate structures may be from 30 to 50 nm, such as 42 nm. In embodiments, an opening may be present between two opposing lateral sides (e.g. each covered by the spacer material) of two gate structures, the opening having a width of from 10 to 20 nm, such as 14 nm. In embodiments, a width of a fin or nanowire structure may be from 5 to 15 nm, such as 10 nm.

In a second aspect, the present invention relates to a semiconductor structure, comprising:
i. at least one source or drain region, comprising a recess or a separation formed by sides separated by an intervening space, and
ii. a contact covering at least the recess or the sides of the separation and contacting the source or drain region on at least 3 sides of the source or drain region.

In any embodiments of the first or second aspect, the contact may be a wrapped around contact (i.e. a contact covering at least one sidewall of the source or drain region). In any embodiments of the first or second aspect, the contact may be layer following the contour of the source or drain region (see e.g. Fig. 2). In any embodiments of the first or second aspect, the contact may be a layer embedding the source or drain region (see e.g. Fig. 6).

In embodiments, the recess may be a V-shaped groove in a top side of the source or drain region (see e.g. Fig. 2a); preferably defined by at least one, yet more preferably two, planes of Miller indices (111) of the source or drain region.

In embodiments, one or more recesses may be present in a lateral side of the source or drain region (see e.g. Fig. 2b).

In embodiments, the one or more separation of the source or drain region may be present (see e.g. Fig. 2c).

In embodiments, the different features of the second aspect and its embodiments may independently be as correspondingly described for the first aspect and its embodiments.

In a third aspect, the present invention relates to a semiconductor device comprising the semiconductor structure according to the second aspect or embodiments thereof.

In embodiments, the different features of the third aspect and its embodiments may independently be as correspondingly described for the first or second aspect and their embodiments.

The invention will now be described by a detailed description of several embodiments of the invention. It is clear that other embodiments of the invention can be configured according to the knowledge of the person skilled in the art without departing from the true technical teaching of the invention, the invention being limited only by the terms of the appended claims.

Reference will be made to transistors. These are devices having a first main electrode such as a drain, a second main electrode such as a source and a control electrode such as a gate for controlling the flow of electrical charges between the first and second main electrodes.

It will be clear for a person skilled in the art that the present invention is also applicable to similar devices that can be configured in any transistor technology, including for example, but not limited thereto, CMOS, BICMOS, Bipolar and SiGe BICMOS technology. Furthermore the findings of the present invention are explained with reference to PMOS and NMOS transistors as an example, but the present invention includes within its scope a complementary device whereby PMOS and NMOS transistors become NMOS and PMOS transistors, respectively. A skilled person can make such modifications without departing from the true technical teachings of the invention.

### Example 1: Embodiments of the present invention compared to the prior art.

We now refer to Fig. 1 and 2. Schematical cross-sections of contacts (900) wrapped around source or drain regions according to the prior art (Fig. 1) and embodiments of the present invention (Fig. 2a-c) are shown. The contact area of the contacts (900) in each figure scales with the indicated lengths of the contacted sides, increasing from Fig. 1 to Fig. 2c; i.e. 2H+W (Fig. 1) < 2H+2L₁ (Fig. 2a) < 2H₁+4H₂+2H₃+2H₄+8L₂+W (Fig. 2b) < 6H₅+5W (Fig. 2c). Each of the depicted embodiments (Fig. 2a-c) of the present invention thus corresponds to an increase of the contact area compared to the prior art (Fig. 1).

### Example 2: Formation of a FinFET with V-shaped grooves in a top side of the source or drain region

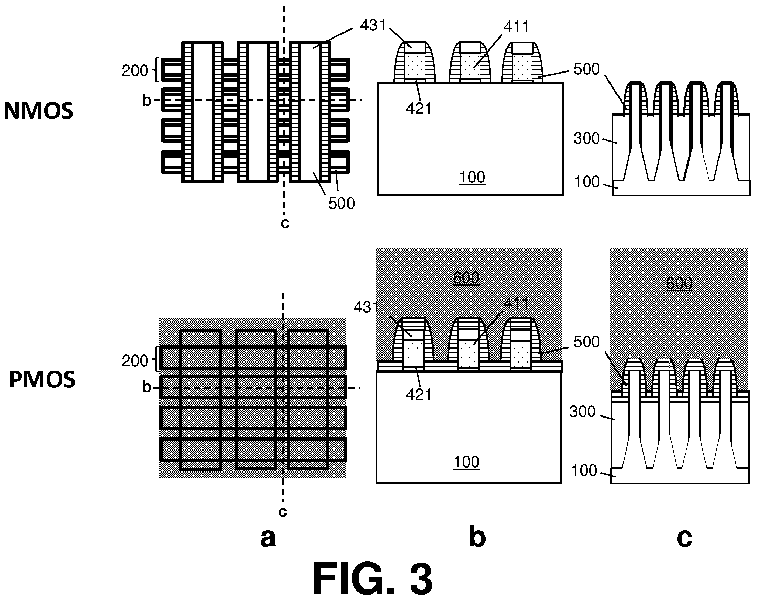

We now refer to Fig. 3. A semiconductor substrate (100) is provided comprising fin structures (200). Dummy gate structures (411; 421) are present on the fin for both n-type metal-oxide-semiconductor field effect transistor (NMOS) and p-type metal-oxide-semiconductor field effect transistor (PMOS) devices; the dummy gate structures (411; 421) define a channel area beneath them in the fin structures (200). The fin structures (200) of the semiconductor substrate are isolated by a shallow trench isolation, or field oxide (300). The shallow trench isolation is recessed such as to expose the top of the fins and the exposed fin parts are covered on at least its sides with a spacer material (500). The dummy gate structures (411, 421) comprise a gate dielectric (421), and an amorphous Si gate (411). An oxide hardmask (431) covers the dummy gate structures (411, 421), while the spacer material (500) covers the lateral sides of the dummy gate structures (411, 421).

Further depicted in Fig. 3 is a photoresist layer (600) covering the PMOS device area as part of the formation of a mask layer, such that the NMOS device area may be processed separately from the PMOS device area. Subsequently removing the mask layer and applying a further mask layer above the NMOS device area (not depicted), in turn allows the PMOS device area to be processed separately. This approach may be used at various stages of device formation (not depicted), whenever it is desired to be able to process the NMOS and PMOS device areas separately.

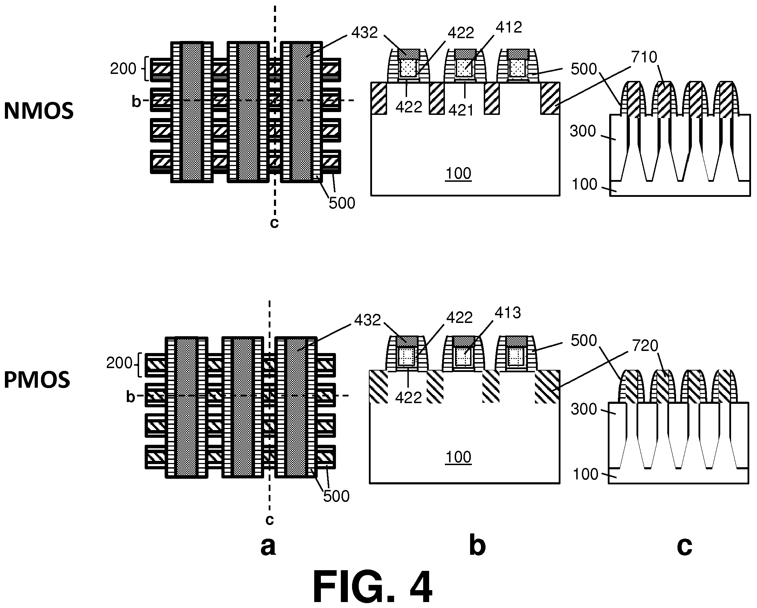

We now refer to Fig. 4. Following a replacement metal gate process, the hardmask (431) is opened and the amorphous Si gate (411) in the dummy gate structures (411, 421) in the NMOS device area is replaced by a high-k dielectric (422) lining the side walls of the opening and the top of the gate dielectric (421), and an NMOS work function metal stack (412) filling the lined opening, thereby forming a gate structures (412, 421, 422). The gate structures (412, 421, 422) are each covered with a gate cap (432), while the lateral sides of the gate structures (412, 421, 422) remain covered by the spacer material (500). Furthermore, the spacer material (500) on top of the fins is opened and the top of the fins is replaced by a P doped Si source or drain region (710), with the lateral sides of the source or drain region (710) covered by the spacer material (500).

A similar procedure is performed in the PMOS device area, differening in that that the dummy gates (411) are replaced by a PMOS work function metal stack (413) and the top of the fins is replaced by a B doped SiGe_{50%} source or drain region (720).

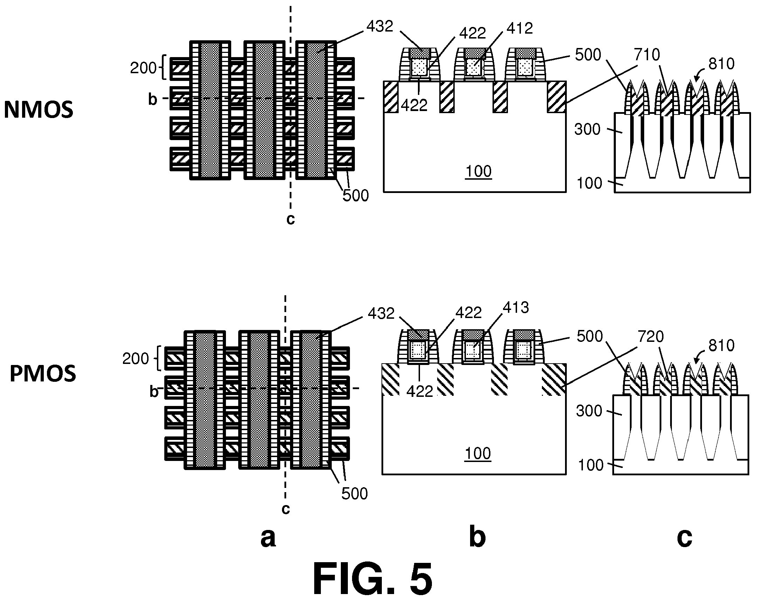

We now refer to Fig. 5. V-shaped grooves (810) are etched in the NMOS (710) and PMOS (720) source or drain regions in turn.

We now refer to Fig. 6. The spacer material (500) is removed and the NMOS (710) and PMOS (720) source or drain regions, comprising the V-shaped grooves (810), are covered with a contact metal (900). This contact metal (900) is planarized down to the gate cap level using a chemical mechanical polish step.

### Example 3: Formation of a FinFET with recesses in a lateral side of the source or drain region

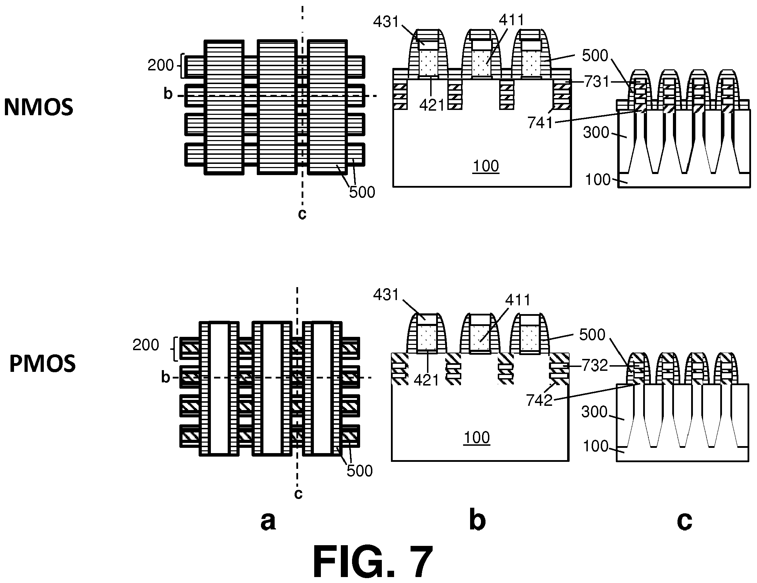

We now refer to Fig. 7. Starting from Fig. 3: in the NMOS device area, the spacer material (500) on top of the fins is opened and the top of the fins is replaced by a stack of layers of P doped Si (741) alternated with P doped SiGe_{50%} (731) source or drain regions, with the lateral sides of the source or drain region (710) covered by the spacer material (500). In the PMOS device area, the spacer material (500) on top of the fins is opened and the top of the fins is replaced by a stack of layers of B doped SiGe_{50%} (742) alternated with B doped Si (732) source or drain regions, with the lateral sides of the source or drain region (710) covered by the spacer material (500).

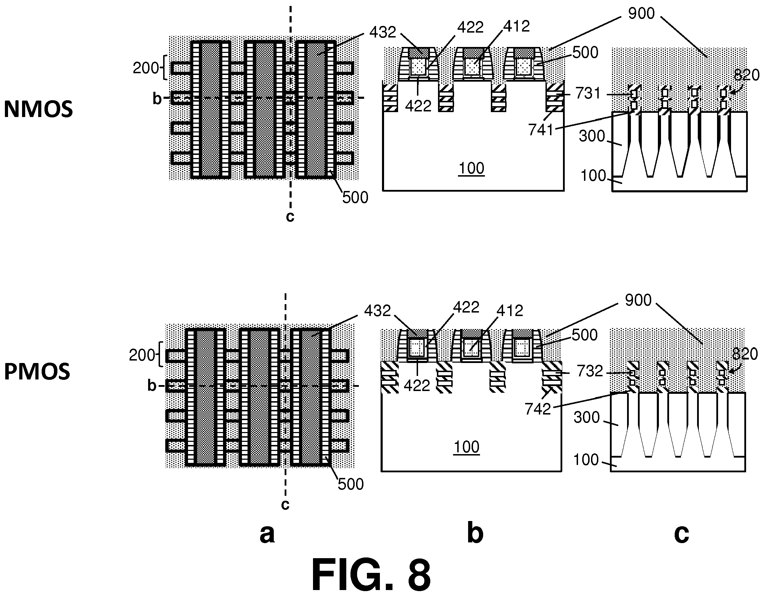

We now refer to Fig. 8. The dummy gate structures (411, 421) are replaced as described in example 2. In the NMOS device area, the recesses (820) are formed in the lateral sides of the source drain region (731, 741) by partially etching back the SiGe_{50%} layers (731), selectively with respect to the Si (741) layers. In the PMOS device area, the recesses (820) are formed in the lateral sides of the source drain region (732, 742) by partially etching back the Si layers (732), selectively with respect to the SiGe_{50%} (742) layers. The source or drain regions (731, 741; 732, 742) with recesses (820) are subsequently covered with the contact metal (900).

### Example 4: Formation of a FinFET with divide forming recesses in a lateral side of the source or drain region

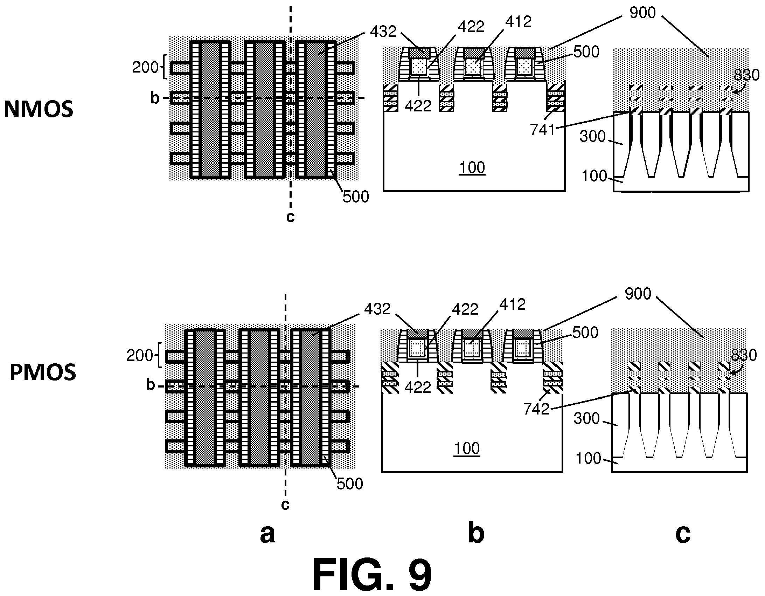

We now refer to Fig. 9. Starting from Fig. 7: the same procedure is followed as described in example 3 with respect to Fig. 8, however the etching of the SiGe_{50%} layers (731) in the NMOS device area and the Si layers (732) in the PMOS device area is performed such that the layers are completely removed and recesses (830) are formed.

### Example 5: Formation of a NanowireFET with recesses in a side of the source or drain region

The procedures described in example 2 to 4 for FinFETs may also be applied for NanowireFETs. As an example the formation of a NanowireFET with V-shaped grooves in a top side of the source or drain region is briefly described hereunder.

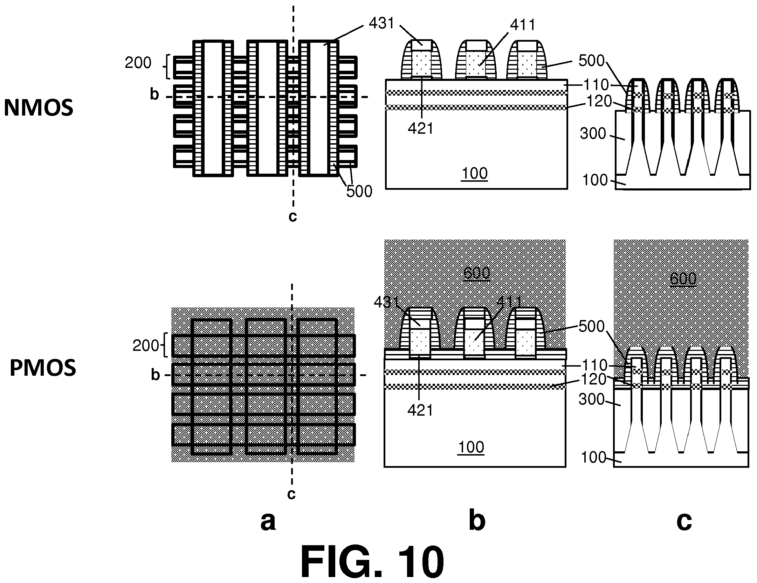

We now refer to Fig. 10. A structure similar to example 2 is provided, differing in that the fin structures comprise SiGe sacrificial layers (120), and Si nanowires (110) in which the channel area will be defined.

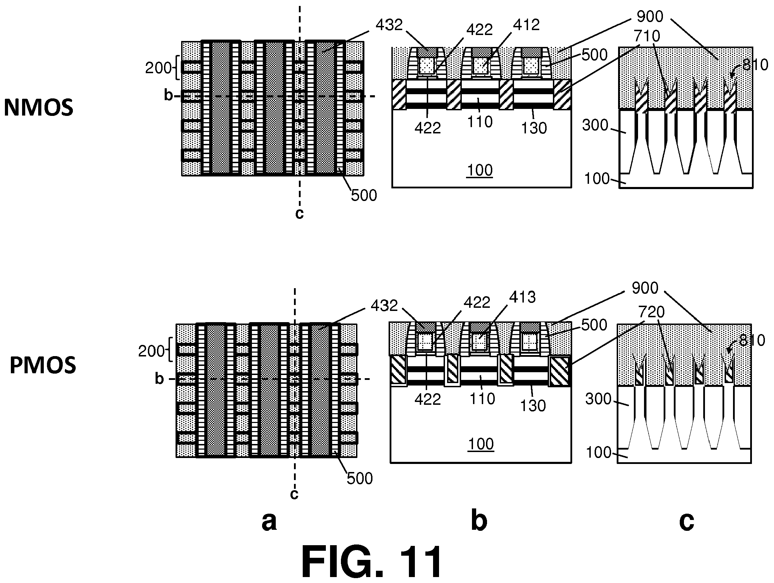

We now refer to Fig. 11. The sacrificial layers (120) are removed (130) from between the nanowires (110). Furthermore, a sequence of steps such as described in example 2 is performed, comprising replacing the dummy gate structures (411, 421), forming the source or drain regions (710; 720) with V-shaped grooves (810) therein and covering the source or drain regions (710; 720) with V-shaped grooves (810) with a contact metal (900).

It is to be understood that although preferred embodiments, specific constructions and configurations, as well as materials, have been discussed herein for devices according to the present invention, various changes or modifications in form and detail may be made without departing from the scope and technical teachings of this invention. For example, any formulas given above are merely representative of procedures that may be used. Functionality may be added or deleted from the block diagrams and operations may be interchanged among functional blocks. Steps may be added or deleted to methods described within the scope of the present invention.

## Claims

1. A method for making a contact (900) to a source or drain region (710; 720; 731,741; 732, 742) of a semiconductor device, comprising:
a. providing the semiconductor device having at least one source or drain region (710; 720; 731,741; 732, 742), the source or drain region (710; 720; 731,741; 732, 742) having an exposed area,
b. partially etching the source or drain region (710; 720; 731,741; 732, 742) such that the exposed area is increased, and
c. providing a contact (900) covering at least the etched part of the source or drain region (710; 720; 731,741; 732, 742);
wherein the contact (900) contacts the source or drain region (710; 720; 731,741; 732, 742) on at least 3 sides of the source or drain region (710; 720; 731,741; 732, 742).

2. The method according to claim 1, wherein the semiconductor device is a fin field effect transistor or a nanowire field effect transistor.

3. The method according to claim 1 or 2, wherein step b of partially etching the source or drain region (710; 720; 731,741; 732, 742) comprises recessing part of a top side or of a lateral side of the source or drain region (710; 720; 731,741; 732, 742).

4. The method according to claim 3, wherein step b forms a V-shaped groove (810) in the top side.

5. The method according to claim 4, wherein the source or drain region (710; 720; 731,741; 732, 742) comprises Si or SiGe.

6. The method according to claim 4 or 5, wherein the V-shaped groove (810) is defined by at least one, preferably two, planes of the source or drain region (710; 720; 731,741; 732, 742) having miller indices (111).

7. The method according to claim 3, wherein the source or drain region (710; 720; 731,741; 732, 742) comprises a layer of a first material (731; 732) on top of a layer of a second material (741; 742) and wherein recessing part of the lateral side (820; 830) comprises selectively etching at least part of the second material with respect to the first material.

8. The method according to claim 7, wherein recessing part of the lateral side comprises selectively etching away the entire layer of second material, thereby forming a separation in the lateral side.

9. The method according to claim 7 or 8, wherein the source or drain region (710; 720; 731,741; 732, 742) comprises layers of the first material alternated with layers of the second material.

10. The method according to any of claims 7 to 9, wherein the first material is Si or SiGe.

11. The method according to any of claims 7 to 10, wherein the second material is selected from SiGe and Si, with the proviso that the second material differs from the first material.

12. The method according to any of the previous claims, wherein the source or drain region (710; 720; 731,741; 732, 742) is doped.

13. A semiconductor structure comprising:
i. at least one source or drain region (710; 720; 731,741; 732, 742), comprising a recess (810; 820) or a separation (830) formed by sides separated by an intervening space, and
ii. a contact (900) covering at least the recess (810; 820) or the sides of the separation (830) and contacting the source or drain region (710; 720; 731,741; 732, 742) on at least 3 sides of the source or drain region (710; 720; 731,741; 732, 742).

14. The semiconductor structure according to claim 13, wherein the contact (900) is a wrapped around contact.

15. A semiconductor device comprising the semiconductor structure according to claim 13 or 14.
